# EUROPÄISCHE PATENTSCHRIFT

(11) **EP 0 330 909 B1**
(45) Veröffentlichungstag und Bekanntmachung des Hinweises auf die Patenterteilung: **28.12.1994**
(21) Anmeldenummer: 89102571.0
(22) Anmeldetag: 15.02.1989
(51) Int. Cl.: H05K 3/30, H01L 21/58, C09J 5/00

(54) **Verfahren zum Befestigen von Bauteilen auf einer Leiterplatte**
Process for mounting parts on a printed-circuit board
Procédé pour fixer des éléments sur un circuit imprimé

(30) Priorität: 02.03.1988 DE 3806738
(43) Veröffentlichungstag der Anmeldung: 06.09.1989
(73) Patentinhaber: THERA Patent GmbH & Co. KG Gesellschaft für industrielle Schutzrechte, D-82229 Seefeld (DE)
(72) Erfinder: Ellrich, Klaus, Dr. Dipl.-Chem., D-8031 Wörthsee (DE); Gasser, Oswald, Dr. Dipl.-Chem., D-8031 Seefeld (DE); Guggenberger, Rainer, Dr. Dipl.-Chem, D-8031 Hechendorf (DE); Wanek, Erich, Dr. Dipl.-Chem., D-8031 Seefeld (DE)
(74) Vertreter: Bunke, Holger, Dr.rer.nat. Dipl.-Chem.

(56) Entgegenhaltungen:
- EP-A- 0 154 819
- EP-A- 0 182 744
- WO-A-85/01634
- GB-A- 2 014 791
- GB-A- 2 065 124
- GB-A- 2 119 810

## Beschreibung

Die Erfindung betrifft ein Verfahren zum Befestigen von Bauteilen auf einer Leiterplatte durch Auftragen eines photoaktivierbaren Klebstoffs auf vorbestimmte Flächen der Bauteile oder der Leiterplatte, Bestücken der Leiterplatte mit den Bauteilen, Härten der Klebeverbindung bei einer Temperatur zwischen 60 und 140°C sowie Herstellung von Lötverbindungen zwischen den Bauteilen und der Leiterplatte.

Ein solches Verfahren ist aus der DE-PS 29 04 649 bekannt. Dabei werden nach der sogenannten "Surface Mounted Technology (SMT)" elektronische Bauteile wie Kondensatoren, Widerstände und dergleichen auf Leiterplatten, z.B. Printplatten, gedruckten Schaltungen, Hybrid-IC's und dergleichen unter Verwendung eines photoaktivierbaren Klebstoffs befestigt, wobei die Klebeverbindung in erster Linie dazu dient, die Bauteile solange auf der Leiterplatte unverrückbar festzuhalten, bis die Lötverbindungen zwischen den Bauteilen und der Leiterplatte hergestellt worden sind.

Bei dem bekannten Verfahren werden als Klebstoffe UV-härtbare Harze verwendet, die einen Anteil an polymerisierbaren Monomeren, Photosensibilisatoren, Initiatoren sowie gegebenenfalls eine Reihe von Füllstoffen enthalten.

Diese UV-härtbaren Acrylatharze härten an den lichtzugänglichen Stellen rasch aus, bedürfen aber zur Aushärtung abgeschatteter Bereiche, also vor allem dort, wo sie durch die Bauteile verdeckt sind, eines zweiten Härtungsmechanismus, der durch Initiatoren der thermischen Polymerisation bewirkt wird und hohe Temperaturen erfordert. Je höher aber die Temperaturbelastung der elektronischen Bauelemente ist, um so geringer ist ihre statistische Lebenserwartung.

Es wurde deshalb bereits versucht, die Temperaturbelastung bei der thermischen Aushärtung der Klebemassen dadurch zu senken, daß pro Bauteil mindestens zwei Klebstoffpunkte zur Hälfte unter und zur Hälfte direkt neben das Bauteil gesetzt wurden, um so den Aushärtungsgrad in der ersten, UV-induzierten Härtungsstufe zu erhöhen. Integrierte Schaltkreise (Chips) mit rings um das Gehäuse angeordneten Anschlußbeinchen haben jedoch keinen freien Raum für solche Klebstofftropfen-Hälften.

Die bei dem bekannten Verfahren verwendeten UV-härtbaren Klebstoffe sind außerdem gegenüber atmosphärischem Sauerstoff empfindlich. Ferner kann die bei Chip-Klebstoffen oft geforderte starke Einfärbung des Klebstofftropfens die Eindringtiefe der UV-Strahlung vermindern, die vollständige Aushärtung somit verhindern und später zu Korrosionserscheinungen führen.

Aus der EP-A-0 182 744 sind photohärtbare, Füllstoffe enthaltende Epoxidharz-Zusammensetzungen bekannt, die mindestens einen Photoinitiator vom Metallocen-Typ enthalten und die unter anderem zum Aufkleben aktiver und passiver Komponenten der Mikroelektronik auf Leiterplatten verwendet werden können, sofern die Massen elektrisch leitende Füllstoffe enthalten. Die UV-induzierte Photohärtung wird dabei gegebenenfalls von einer thermischen Nachhärtung gefolgt.

Die EP-A-0 279 199 (nachveröffentlicht) beschreibt ein Verfahren und eine Vorrichtung zur Verarbeitung von UV-härtbaren Reaktionsharzmassen, bei welchem die UV-härtbare Reaktionsharzmasse in der Applikationsvorrichtung bestrahlt und unmittelbar einem Substrat oder einer Gießform zugeführt wird. Ein Verfahren zum Befestigen von Bauteilen auf einer Leiterplatte ist dort jedoch nicht beschrieben. Ebenso beschreibt die JP-A-61-98740 die Herstellung von Form- und Beschichtungsmassen über eine UV-voraktivierte Harzmatrix. Ein Verfahren zum Befestigen von Bauteilen auf einer Leiterplatte ist jedoch ebenfalls nicht erwähnt.

Aus der WO-A-8501634 ist ein Verfahren zum Befestigen von Bauteilen auf einer Leiterplatte bekannt, bei dem ein photoaktivierbarer Klebstoff auf vorbestimmte Flächen der Bauteile oder der Leiterplatte aufgetragen und anschließend in einem UV-Tunnel mit ultraviolettem Licht bestrahlt wird. Anschließend wird die Leiterplatte mit den Bauteilen bestückt, wonach die Lötverbindungen zwischen den Bauteilen und der Leiterplatte hergestellt werden. Als Klebstoff wird ein Haftkleber verwendet, der bereits in der UV-Station aushärtet.

Aus der GB-A-2 065 124 ist ein Klebeverfahren bekannt, bei dem ein photoaktivierbarer Klebstoff auf mindestens eines der miteinander zu verbindenden Substrate aufgetragen und mit sichtbarem Licht aktiviert wird. Anschließend werden die miteinander zu verbindenden Teile gefügt, wonach man den Verbund in der Dunkelheit stehenläßt, bis der Kleber vollständig ausgehärtet ist. Dabei wird als Klebemasse eine Zusammensetzung verwendet, die aus einem epoxidischen Prepolymer, einem Iodoniumsalz als Initiator und einem Farbstoff als Aktivator für den Photoinitiator besteht.

Der Erfindung liegt die Aufgabe zugrunde, ein Verfahren zum Befestigen von Bauteilen, insbesondere von SMD's (Surface Mounted Devices), auf einer Leiterplatte zu schaffen, mit dem es gelingt, die verwendete Klebstoffmasse in kürzerer Zeit und bei niedrigeren Temperaturen als bei den bekannten Verfahren aushärten zu lassen, ohne jedoch das Netzvermögen des Klebstoffs während des Bestückens der Leiterplatte zu verringern.

Diese Aufgabe wird bei einem Verfahren der eingangs genannten Gattung erfindungsgemäß dadurch gelöst, daß ein Klebstoff, bestehend aus
a) 10 bis 99,95 Gew.% mindestens eines kationisch härtbaren Harzes und/oder eines kationisch polymerisierbaren Monomers,
b) 0,05 bis 10 Gew.% mindestens eines Photoinitiators, der unter Lichteinwirkung Lewis- oder Brönsted-Säuren bildet,
c) 0 bis 89,95 Gew.% eines oder mehrerer Füllstoffe, thixotropierender Mittel und/oder Haftvermittler,

durch Bestrahlen mit Licht von einer Wellenlänge im Bereich von 200 bis 600 nm vor dem Bestücken der Leiterplatte soweit aktiviert wird, daß die gewünschte Initialklebrigkeit erhalten bleibt und keine Hautbildung an der Klebstoffoberfläche eintritt.

Die Initialklebrigkeit des aktivierten Klebstoffs erlaubt es, daß die Leiterplatte nach dem Bestücken mit den Bauteilen dorthin transportiert werden kann, wo die thermische Härtung der Klebeverbindung erfolgt. Der Fachmann kann anhand einfacher Vorversuche ohne Schwierigkeit feststellen, wie groß die im Einzelfall von Art und Material der Bauteile sowie der Leiterplatte abhängige Initialklebrigkeit sein muß. Die Initialklebrigkeit muß in jedem Falle so groß sein, daß die Bauteile beim Transport von der Bestückungsstation zu der Station, in der die thermische Aushärtung des Klebers stattfindet, nicht auf der Leiterplatte verrücken, ihre exakt vorbestimmte Lage also nicht verändern.

Das erfindungsgemäße Verfahren hat den Vorteil, daß photoaktivierbare Einkomponenten-Massen zum Befestigen der Bauteile eingesetzt werden, die eine hohe Lagerstabilität aufweisen, aber nach dem Aktivieren sehr schnell bei niedrigen Temperaturen auspolymerisieren. Infolge der Langlebigkeit der im Belichtungsschritt erzeugten aktivierten Spezies ist es möglich, die verwendeten Massen vor dem Aufsetzen der Bauteile zu belichten. Der im Stand der Technik aufgetretene Nachteil einer nicht ausgehärteten Kleberschicht in abgeschatteten Zonen kann daher beim erfindungsgemäßen Verfahren nicht auftreten. Beide Stufen der Härtung, also sowohl die UV-induzierte Aktivierung als auch die thermische Aushärtung, erfolgen bei dem erfindungsgemäßen Verfahren gleichmäßig durch die gesamte aufgetragene Kleberschicht, gleichgültig, ob diese nach dem Bestücken durch ein Bauteil abgedeckt oder frei zugänglich und sichtbar ist.

Das erfindungsgemäße Verfahren weist ferner folgende Vorteile auf:
- Geringe Flüchtigkeit sowie Viskosität und geringes toxisches Potential der verwendbaren Monomeren,
- keine Inhibierung der Reaktion durch Luftsauerstoff und dadurch keine Schmierschicht,
- hervorragende Haftung auf unterschiedlichen Substraten,
- hervorragende chemische und physikalische Eigenschaften der Klebstoffschicht,
- schnelle und problemlose Aktivierbarkeit und anschließend extrem schnelle Aushärtungszeit bei niedrigen Aushärtungstemperaturen,
- hohe Lagerstabilität der nichtaktivierten Massen,
- die Festigkeit der Klebeverbindung reicht aus, um die Bauteile bis zur Fertigstellung der Lötverbindungen unverrückbar fest auf der Leiterplatte zu halten, ist aber andererseits - im Gegensatz zu leitfähigen Klebeverbindungen - nicht so groß, daß die Bauteile nicht nachträglich, z.B. bei einer Reparatur, ohne Gefahr einer Beschädigung wieder entfernt werden könnten.

Mit dem erfindungsgemäßen Verfahren ist es möglich, den Aktivierungsschritt durch Einstellung der Belichtungszeit, der Energiedosis der verwendeten aktinischen Lampen sowie des Wellenlängenbereichs des verwendeten Lichts so einzustellen, daß einerseits genügend reaktive Spezies für die nachfolgende schnelle Aushärtung erzeugt wird, aber andererseits noch keine Polymerisation an der Oberfläche unter Bildung einer Haut, die eine gute Benetzung der Bauteile verhindern und damit die Klebemasse ungeeignet machen würde, stattfindet.

Die Bildung einer oberflächlichen Polymerschicht (Hautbildung) tritt bei allen bekannten Massen des Standes der Technik ein, die bisher zum Verkleben von Bauteilen auf Leiterplatten eingesetzt wurden und mindestens teilweise unter Strahlungseinfluß aushärten sollten. Demgegenüber ist bei dem erfindungsgemäßen Verfahren nach dem Aufsetzen des Bauteils eine Belichtung nicht mehr nötig, wodurch sich eine Abschattung durch das Bauteil oder die Leiterplatten nicht mehr störend auswirken kann. Durch die der Bestückung vorausgehende Aktivierung des verwendeten Klebstoffs wird die anschließende Wärmehärtung so stark beschleunigt, daß sie wesentlich schneller vonstatten geht als bei den bisher bekannten wärmehärtbaren Klebern, die zum Verkleben von Bauteilen auf Leiterplatten eingesetzt wurden.

Die UV-induzierte Aktivierung des Klebstoffs kann bei dem erfindungsgemäßen Verfahren entweder nach dem Auftragen der Klebstoffschicht auf die Leiterplatte oder auf die zu verklebende Oberfläche des Bauteils oder auch bereits vor dem Auftragen des Klebstoffs, beispielsweise in der Auftragsvorrichtung, etwa einem Dispenser, durch Bestrahlen mit Licht von einer Wellenlänge im Bereich von 200 bis 600 nm durchgeführt werden. Wenn die Aktivierung vor dem Auftragen des Klebstoffs erfolgt, wird sie vorzugsweise innerhalb eines Zeitraums von 1 sec. bis 10 Min., vorzugsweise innerhalb eines Zeitraums von 1 Min., vor dem Beginn des Klebstoffauftrags auf die Leiterplatte oder das Bauteil durchgeführt. Hierbei wird vorzugsweise die Belichtung in Intensität und Zeitdauer so gewählt, daß der voraktivierte Klebstoff vor dem Auftragen für einen Zeitraum von mindestens 1 Minute bis vorzugsweise mindestens 5 Minuten, besonders bevorzugt bis mindestens 20 Minuten, praktisch keine Viskositätsänderung aufweist, die die gewünschte Initialklebrigkeit nennenswert vermindern würde oder eine störende Hautbildung an der Klebstoffoberfläche erwirken würde.

Vorteilhafte Ausführungsformen des erfindungsgemäßen Verfahrens bestehen darin, daß die Aktivierung des Klebstoffs durch Bestrahlen mit Licht einer Wellenlänge von 300 bis 500 nm während eines Zeitraums von 0,5 bis 300 sec. erfolgt und daß das Härten der Klebeverbindung nach dem Bestücken der Leiterplatte während einer Zeitspanne von bis zu 15 Min. erfolgt. In einer weiteren bevorzugten Ausführungsform des erfindungsgemäßen Verfahrens wird die Aktivierung des Klebstoffes mit Tageslicht bzw. Tageslichtgeräten durchgeführt, vorzugsweise mit einer Wellenlänge von 400 bis 600 nm, besonders bevorzugt 400 bis 500 nm. Die auf diese Weise erzielte Haftfestigkeit der Klebeverbindung ist in jedem Falle so groß, daß sie der mechanischen Beanspruchung während des anschließenden Lötvorgangs, insbesondere im Schwall- oder Schlepplötbad, ohne weiteres standhält, und zwar bei gleichzeitig optimal niedriger Temperaturbelastung der elektronischen Bauelemente.

Vorteilhafte Weiterbildungen des erfindungsgemäßen Verfahrens bestehen ferner darin, daß als photoaktivierbarer Klebstoff eine kationisch härtbare, vor der Aktivierung fließfähige Klebstoffmasse mit einer Viskosität von 0,05 bis 1000 Pa.s verwendet wird. Ein guter Kompromiß zwischen Verarbeitbarkeit und den benetzenden Eigenschaften der verwendeten Klebstoffmassen wird bei einer Viskosität dieser Massen, vor ihrer Aktivierung gemessen, von 0,1 bis 500 Pa.s erzielt, wobei sich ein Bereich von 0,4 bis 200 Pa.s als besonders vorteilhaft herausgestellt hat.

Als photopolymerisierbare Masse, die im wesentlichen nach einem kationischen Reaktionsmechanismus polymerisiert, wird erfindungsgemäß vorzugsweise ein Gemisch verwendet, das besteht aus:
a) 70 bis 98 Gew.% mindestens eines kationisch härtbaren Harzes und/oder eines kationisch polymerisierbaren Monomers;
b) 2 bis 6 Gew.% mindestens eines Photoinitiators, der unter Lichteinwirkung Lewis- oder Brönsted-Säuren bildet;
c) 0 bis 28 Gew.% eines oder mehrerer Füllstoffe, thixotropierender Mittel und/oder Haftvermittler.

Gemäß einer weiteren bevorzugten Ausführungsform des erfindungsgemäßen Verfahrens können auch solche photopolymerisierbare Massen (Harze und/oder Monomere) benutzt werden, die neben einem kationischen auch einem radikalischen Härtungsmechanismus folgen. Solche Klebstoffmassen bestehen aus:
a) 10 bis 89,9 Gew.% mindestens eines kationisch härtbaren Harzes und/oder eines kationisch polymerisierbaren Monomers;
b) 0,05 bis 10 Gew.% mindestens eines Photoinitiators, der unter Lichteinwirkung Lewis- oder Bronsted-Säuren bildet;
c) 0 bis 89,9 Gew.% eines oder mehrerer Füllstoffe, thixotropierender Mittel und/oder Haftvermittler,
d) 10 bis 80 Gew.% mindestens eines nach einem radikalischen Polymerisationsmechanismus polymerisierenden Harzes und/oder Monomers;
e) 0,05 bis 5 Gew.% mindestens eines Photoinitiators, der unter Lichteinwirkung Radikale erzeugt;
f) gegebenenfalls 0,05 bis 5 Gew.% mindestens eines Photosensibilisators und/oder Aktivators.

Dabei bestehen die nach einem radikalischen Polymerisationsmechanismus polymerisierenden Harze und/oder Monomere vorzugsweise aus den Acrylsäure- und/oder Methacrylsäureestern ein- oder mehrwertiger Alkohole, wobei die Acrylsäure- und/oder Methacrylsäureester mehrwertiger Alkohole besonders bevorzugt sind.

Zur Verwendung im Rahmen des erfindungsgemäßen Verfahrens eignen sich als kationisch härtbare Harze oder kationisch polymerisierbare Monomere beispielsweise mono- oder polyfunktionelle Vinylether und Vinylester. Geeignete Vinylether sind Trimethylolpropan-Trivinylether, Ethylenglykol-Divinylether und cyclische Vinylether. Besonders geeignet ist Triethylenglykoldivinylether.

Allgemein gut geeignete Verbindungen sind die Vinylester und Vinylether polyfunktioneller Alkohole, wobei Polyethylenund Polypropylenglykole mit Vinylether-Endgruppen bevorzugt eingesetzt werden.

Weiterhin gut geeignet sind kationisch polymerisierbare heterocyclische Verbindungen, beispielsweise Epoxide. Bevorzugt verwendet werden hierbei die Glycidylether ein- und mehrwertiger Alkohole, beispielsweise die Diglycidylether von Bisphenol-A. Zur Einstellung einer hohen Reaktivität sind besonderes geeignet die Di- und Polyepoxide cycloaliphatischer Verbindungen, beispielsweise die Glycidylether und β-Methylglycidylether cycloaliphatischer Diole und Polyole.

Verwendbar sind ferner als Glycidylverbindungen die Glycidylester von Carbonsäuren, insbesondere von Di- und Polycarbonsäuren, beispielsweise die Glycidylester von Bernsteinsäure, Adipinsäure, Phthalsäure.

Beispiele für besonders reaktive Glycidylverbindungen sind die Diepoxide des Vinylcyclohexans und des Dicyclopentadiens sowie 3-(3′,4′-Epoxycyclohexyl)-8,9-epoxy-2,4-dioxyspiro(5.5)undecan und 3,4-Epoxycyclohexylmethyl-3′,4′-epoxycyclohexylcarboxylat.

Bevorzugte Epoxidharze sind gegebenenfalls vorverlängerte und/oder prepolymere Diglycidylether zweiwertiger Phenole oder zweiwertiger aliphatischer Alkohole mit zwei bis vier C-Atomen. Besonderes bevorzugt verwendet werden die vorverlängerten Diglycidylether des 2,2-bis-(4-Hydroxyphenyl)propans.

Als Photoinitiatoren, die unter Lichteinwirkung Lewis- oder Brönsted-Säuren bilden, eignen sich ganz allgemein die für die kationische Polymerisation bekannten Photoinitiatoren, beispielsweise Aryldiazoniumsalze, Diaryljodoniumsalze, Triarylsulfoniumsalze sowie metallocenartige Komplexsalze.

Eine für die erfindungsgemäßen Zwecke bevorzugte Photoinitiatorenklasse sind die aus der EP-A-0 182 744 bekannten Metallocen-Komplexsalze, insbesondere die Verbindungen (Ia) und (Ib):

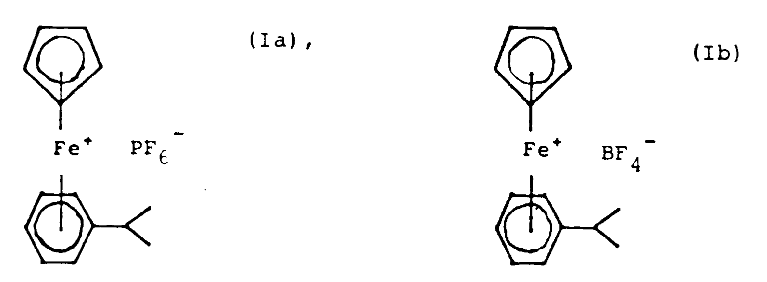

Eine weitere bevorzugte Klasse von Photoinitiatoren für die kationische Polymerisation sind die Diaryljodoniumsalze der Formel:

Ar₂J⁺X⁻,

worin Ar ein gegebenenfalls substituiertes Aren ist, beispielsweise Benzol, Toluol, Xylol, Ethylbenzol, Methoxybenzol, Naphthalin, 1,2-Dihydronaphthalin, Phenanthren, Anthracen, 9,10-Dihydroanthracen, Diphenylen, Biphenyl, Cumol; und worin X⁻ ein komplexes Anion, beispielsweise BF₄-, PF₆⁻, AsF₆⁻, SbF₆⁻, vorzugsweise BF₄⁻ oder PF₆⁻, ist.

Besonders bevorzugt sind Diphenyljodonium-tetrafluoroborat, Ditoluyljodonium-tetrafluoroborat, Ditoluyljodonium-hexafluorophosphat und Di-t-butylphenyljodonium-tetrafluoroborat. Weitere geeignete Diaryljodoniumsalze finden sich beispielsweise in "UV-Curing", Science and Technology, Ed. by S. Peter Pappas, Technology Marketing Corporation, Norwalk, USA 06851 (1980).

Vorzugsweise werden die Diaryljodoniumsalze zusammen mit Photoinitiatoren, die unter Lichteinwirkung Radikale erzeugen, eingesetzt. Geeignete derartige Photoinitiatoren sind Mono- und α-Diketone, Benzoine, Benzoinether, Benzilketale sowie insbesondere Acylphosphinverbindungen der allgemeinen Formel II: 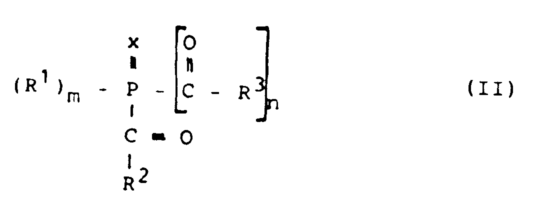
worin m = 1, n = 1 und x = O,
oder m = 2, n = 0 und x = O oder S,
- R¹: einen geradkettigen oder verzweigten C₁₋₆-Alkylrest,
einen Cyclohexyl-, Cyclopentyl-, Phenyl-, Naphthyl- oder Biphenylylrest,
einen Cyclopentyl-, Cyclohexyl-, Phenyl-, Naphthyl- oder Biphenylylrest, der substituiert ist durch F, Cl, Br, J, C₁-C₄-Alkyl und/oder C₁-C₄-Alkoxyl,
einen S- oder N-haltigen 5- oder 6-gliedrigen heterocyclischen Ring,
- R² und R³,: die gleich oder verschieden sind, einen Cyclohexyl-, Cyclopentyl-, Phenyl-, Naphthyl- oder Biphenylylrest,
einen Cyclopentyl-, Cyclohexyl-, Phenyl-, Naphthyl- oder Biphenylylrest, der substituiert ist durch F, Cl, Br, J, C₁-C₄-Alkyl und/oder C₁-C₄-Alkoxyl, oder
einen S- oder N-haltigen 5- oder 6-gliedrigen heterocyclischen Ring oder
- R² und R³: miteinander zu einem Ring verknüpft sind, der 4 bis 10 Kohlenstoffatome enthält und durch 1 bis 6 C₁₋₄-Alkylreste substituiert sein kann.

Als Füllstoffe können in den erfindungsgemäß verwendeten Klebstoffmassen Pulver von Aluminiumoxid, Siliciumdioxid, Calciumcarbonat, Titandioxid, Bariumsulfat, Glimmer und dergleichen enthalten sein, während als thixotropierendes Mittel vorzugsweise pulverförmiges Siliciumdioxid mit einer spezifischen Oberfläche von 50 bis 450 m²/g enthalten sein kann. Die eingesetzten Füllstoffe sind vorzugsweise silanisiert. Als Silanisierungsmittel können die an sich bekannten Silan-Kupplungsmittel, beispielsweise γ-Methacryloyloxypropyltrimethoxysilan und Glycidyloxypropyltrimethoxysilan verwendet werden.

Andere übliche Zusatzstoffe für die erfindungsgemäß verwendeten Klebstoffmassen sind beispielsweise Peroxide, Sensibilisatoren wie z.B. Anthracen, Pigmente, Farbstoffe, Antioxidantien und dergleichen.

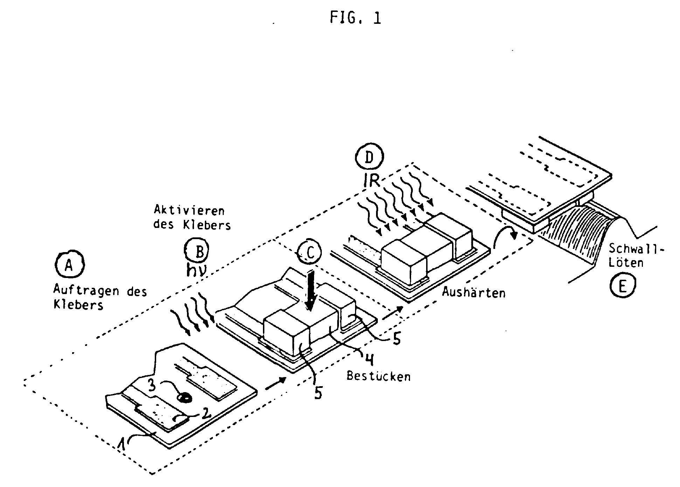

Die Erfindung wird nachfolgend anhand der Zeichnung und der Ausführungsbeispiele weiter erläutert:

Die Zeichnung zeigt schematisch den Ablauf einer der möglichen Ausführungsformen des erfindungsgemäßen Verfahrens zum Befestigen von SMD-Bauteilen auf einer Schaltungs- oder Leiterplatte. Das Verfahren besteht im wesentlichen aus der Folge der Verfahrensschritte A bis E:
A - Auftragen einer Klebstoffschicht 3 auf eine mit Kontaktanschlüssen 2 versehene Leiterplatte 1. Die photopolymerisierbare Klebstoffmasse 3 besitzt eine der vorstehend beschriebenen Zusammensetzungen und polymerisiert im wesentlichen nach einem kationischen Reaktionsmechanismus. Das Auftragen der Klebstoffschicht 3 kann durch Siebdruck, Pin-Transfer oder Dispenserauftrag in an sich bekannter Weise auf vorbestimmte Bereiche der Leiterplatte 1 erfolgen. Alternativ kann die Klebstoffmasse 3 auch auf die Unterseite des auf der Leiterplatte 1 zu befestigenden Bauteils 4 aufgetragen werden.
B - Aktivieren der Klebstoffschicht 3 durch Bestrahlen mit aktinischem Licht im ultravioletten oder sichtbaren Wellenlängenbereich zwischen 200 und 600 nm, vorzugsweise zwischen 400 und 500 nm, und zwar soweit und so lange, bis die gewünschte Initialklebrigkeit, jedoch keine Hautbildung an der Klebstoffoberfläche, eintritt.
C - Bestücken der Leiterplatte 1 durch Aufbringen des Bauteils 4 mit seinen Elektroden 5 auf die aktivierte Klebstoffschicht 3 und die Kontaktanschlüsse 2.
D - Aushärten der Klebstoffschicht 3 bei einer Temperatur zwischen 60 und 140°C, beispielsweise in einem Konvektionsofen, mittels Infrarotstrahler oder mittels der in Stufe B benutzten Quelle für aktinische Strahlung, falls diese auch Infrarotstrahlung emittiert.
E - Kontaktierung der (nicht dargestellten) Anschlüsse der Bauteile 4 mit den Leiterbahnen 2 durch Verlöten im Schwall- oder Schlepplötbad.

Bei einer anderen Ausführungsform des erfindungsgemäßen Verfahrens wird die Reihenfolge der Stufen A und B miteinander vertauscht, also die Aktivierung der Klebstoffmasse durch Bestrahlen mit aktinischem Licht bereits vorgenommen, bevor der Kleber entweder auf die Leiterplatte 1 oder die Unterseite des Bauteils 4 aufgetragen wird.

### Beispiel 1

Es wird eine Harzzusammensetzung durch gleichmäßiges Mischen von 100 Gew.-Teilen 3,4-Epoxycyclohexylmethyl-3′,4′-epoxycyclohexylcarboxylat, 3 Gew.-Teilen (η⁵-2,4-Cyclopentadien-1-yl)-[(1,2,3,4,5,6- )-(1-methylethyl)-benzol]-eisen(1+)-hexafluorophosphat(1-) (Irgacure® 261 der Fa. Ciba-Geigy) und 6 Gew.-Teilen pulverförmigen hydrophobierten Siliciumdioxids mit einer spezifischen Oberfläche von 71 m²/g und einer Teilchengröße kleiner 100 nm (Silica R-202 der Fa. Degussa) hergestellt.

Die Harzzusammensetzung weist eine Viskosität von 1,7 Pa.s auf (Haake-Viskosimeter Rotovisko RV 100, PKI 0.5/28, 10 %D). Die Harzzusammensetzung wird anschließend mittels eines Dispensers auf eine gedruckte Leiterplatte in Form eines standfesten Klebstofftropfens zwischen den Kontaktanschlüssen aufgebracht. Der Klebstofftropfen weist ein Verhältnis zwischen Durchmesser und Höhe von ca. 2:1 auf.

Der Klebstofftropfen wird anschließend mit einem Bestrahlungsgerät, welches aktinisches Licht im Bereich von 400 bis 500 nm aussendet (Curelight 01 der Fa. Precon, Lichtleistung ca. 100 mW/cm²), über einen Zeitraum von 20 sec. aktiviert. Danach wird ein Transistor im Gehäuse (Gehäuseform: SOT-23) darauf aufgebracht und mit einer Infrarotlampe (IR-Trocknungsaufsatz YTC01L der Fa. Sartorius, 250 W, Temperatur = 72°C) 1 Minute bestrahlt.

Anschließend wird die so bestückte Leiterplatte in ein Schlepplötbad (Fa. Zevatron Typ EFT-1) eingebracht. Die Leiterplatte wird mit maximaler Geschwindigkeitsstufe 10 in einen auf 250°C erhitzten Behälter mit geschmolzenem Lot eingefahren und 10 sec. eingetaucht belassen, um die zu verlötenden Elektrodenteile des SOT-Gehäuses mit den Verbindungsanschlüssen durch das Lötmittel zu verlöten. Während des Verlötens tritt keine Ablösung des SOT-Gehäuses von der gedruckten Leiterplatte auf, und man erhält ein einwandfrei verlötetes Bauteile.

Das Eintauchen wird 5 x wiederholt, ohne daß eine Ablösung des SOT-Gehäuses von der gedruckten Leiterplatte eintritt.

### Beispiel 2

Die Harzzusammensetzung des Beispiels 1 wird mit zusätzlich 2 Gew.-Teilen silanisiertem Siliciumdioxid (R-202, Fa. Degussa) versetzt und zu einer homogenen Mischung verrührt.

Die Harzzusammensetzung weist eine Viskosität von 2,8 Pa.s (Haake-Viskosimeter Rotovisko RV 100, PKI 0.5/28, 10 %D) auf.

Mit dieser Harzzusammensetzung wird ein zylinderförmiger Widerstand (Melf) mit der Leiterplatte verklebt.

Die Probe wird sofort nach dem Bestrahlen mit der Infrarotlampe (Bedingungen wie in Beispiel 1) auf einem Universalprüfgerät (Fa. Zwick 1435) vermessen. Die Festigkeit der Verbindung zwischen zylinderförmigem Bauteile und Leiterplatte wird durch Abscheren von der Leiterplatte (Vorschubgeschwindigkeit des Stempels 1 mm/Min.) ermittelt. Zum Abscheren des Bauteils ist eine Kraft von durchschnittlich 46 N erforderlich. Da die Fläche des Klebstofftropfens 4 mm² beträgt, kann eine durchschnittliche Scherfestigkeit von 11,5 N/mm² (MPa) ermittelt werden.

### Vergleichsbeispiel 1

Ein gebräuchlicher warmhärtender Einkomponenten-Epoxid-Klebstoff für die Befestigung von SMD-Bauteilen auf Leiterplatten (Fa. Heraeus RD 860002 M) wird mittels eines Dispensers auf die gleiche gedruckte Leiterplatte wie im Beispiel 2 aufgetragen. Danach wird ein zylinderförmiger SMD-Widerstand (Melf) darauf aufgebracht und die Leiterplatte anschließend zur Härtung der Klebstoffschicht nach den Herstellungsangaben in einem Wärmeschrank belassen (Konvektionsofen 120°C, 3 Min.). Danach wird die bestückte Leiterplatte auf einer Universalprüfmaschine (Fa. Zwick 1435) vermessen. Das zylinderförmige SMD-Bauteil wird mittels eines Stempels mit einer Vorschubgeschwindigkeit von 1 mm/Min. abgeschert. Dazu ist eine Kraft von durchschnittlich 41 N erforderlich, woraus sich aus der Fläche des Klebstofftropfens von 5 mm² eine durchschnittliche Scherfestigkeit von 8,2 N/mm² (MPa) errechnet.

Im Vergleich zum erfindungsgemäßen Verfahren werden mit dem handelsüblichen Präparat trotz drastischer Aushärtebedingungen (3 Min. bei 120°C statt 1 Min. bei 72°C) schlechtere Abscherfestigkeiten erhalten.

### Beispiel 3

Es wird eine Harzzusammensetzung durch gleichmäßiges Mischen von 80 Gew.-Teilen 3,4-Epoxycyclohexylmethyl-3′,4′-epoxycyclohexylcarboxylat, 20 Gew.-Teilen eines kationisch härtbaren Harzes (UVR 6351 der Fa. Union Carbide), 3 Gew.-Teilen Irgacure® 261 (der Fa. Ciba-Geigy) und 3 Gew.-Teilen hydrophobierten Siliciumdioxid-Pulvers einer mittleren Teilchengröße von kleiner 100 nm und einer spezifischen Oberfläche von 71 m²/g (Silica R-202 der Fa. Degussa) unter Rühren hergestellt.

Die Viskosität beträgt 1,0 Pa.s (Haake-Viskosimeter Rotovisko RV 100, PKI 0.5/28, 10 %D).

Diese Harzzusammensetzung wird anschließend auf eine gedruckte Leiterplatte unter Verwendung eines Dispensers aufgebracht. Der Klebstofftropfen wird mit einer Ultraviolett-Strahlenquelle (UVAHAND 200 der Fa. Dr. Höhnle GmbH, emittiertes Licht von 315 bis 600 nm) im Abstand von 10 cm bestrahlt, was einer UVA-Bestrahlungsstärke von 15 mW/cm² entspricht. Die Bestrahlungszeit beträgt 30 sec. Danach wird ein Transistor im SOT-23-Gehäuse auf den aktivierten Klebstofftropfen aufgebracht und die gedruckte Leiterplatte mit einer Infrarotlampe (IR-Trocknungsaufsatz YTCO1L der Fa. Sartorius, 250 W) 2 Min. lang bestrahlt, wobei eine Temperatur von 80°C erreicht wird. Sofort nach der Bestrahlung wird die resultierende bestückte Leiterplatte in einem Schlepplötbad (Fa. Zevatron Typ EFT-1, maximale Geschwindigkeitsstufe 10) in einen auf 250°C erhitzten Behälter mit geschmolzenem Lot eingefahren und 10 sec. eingetaucht belassen. Es tritt keine Ablösung des Transistors im SOT-23-Gehäuse von der Leiterplatte auf, und man erhält ein einwandfrei verlötetes Bauteil.

### Beispiel 4

Es wird eine Harzzusammensetzung durch gleichmäßiges Mischen von 100 Gew.-Teilen eines Bisphenol-A-Diepoxids (GY 259 der Fa. Ciba-Geigy), 3 Gew.-Teilen Irgacure® 261 (der Fa. Ciba-Geigy) und 2,5 Gew.-Teilen Cumolhydroperoxid hergestellt.

Die Harzzusammensetzung weist eine Viskosität von 11 Pa.s auf (Haake Viskosimeter Rotovisko RV 100, PKI 0.5/28, 10 %D). Mit dieser Harzzusammensetzung wird die gleiche Probe wie in Beispiel 1 hergestellt, mit der einzigen Ausnahme, daß anstelle des SOT-Gehäuses ein quaderförmiger Elektrolytkondensator (15 D der Fa. Philips) verklebt wird. Die Probe wird sofort nach dem Bestrahlen mit der Infrarotlampe (unter Bedingungen wie in Beispiel 1 genannt) in ein Schlepplötbad (Fa. Zevatron Typ EFT-1) eingebracht. Die Leiterplatte wird mit Geschwindigkeitsstufe 4 in einen auf 250°C erhitzten Behälter mit geschmolzenem Lot eingefahren und 5 sec. eingetaucht belassen. Während des Verlötens tritt keine Ablösung des Elco-Gehäuses von der gedruckten Leiterplatte auf. Die Verlötung ist einwandfrei.

### Beispiel 5

Es wird eine Harzzusammensetzung durch gleichmäßiges Mischen von 50 Gew.-Teilen 3,4-Epoxycyclohexylmethyl-3′,4′epoxycyclohexylcarboxylat, 50 Gew.-Teilen Triethylenglykoldivinylether, 4 Gew.-Teilen Ethylenglykol, 3 Gew.-Teilen Bis-(4-methylphenyl)-jodoniumhexafluorophosphat, 1 Gew.-Teil Bis-(2,6-dichlorbenzoyl)-4-n-propylphenylphosphinoxid und 3 Gew.-Teilen pulverförmigen hydrophobierten Siliciumdioxids mit einer spezifischen Oberfläche von 71 m²/g und einer Teilchengröße von kleiner 100 nm (Silica R-202 der Fa. Degussa) hergestellt.

Die Harzzusammensetzung weist eine Viskosität von 0,05 Pa.s auf (Haake-Viskosimeter Rotovisko RV 100, PKI 0.5/28, 10 %D). Die Harzzusammensetzung wird anschließend mit Hilfe eines Dispensers auf eine gedruckte Leiterplatte in Form eines Klebstofftropfens zwischen den Kontaktanschlüssen aufgebracht.

Der Klebstofftropfen wird anschließend mit einem Bestrahlungsgerät, welches aktinisches Licht im Bereich von 400 bis 500 nm aussendet (Curelight 01 der Fa. Precon, ca. 100 mW/cm²), 20 sec. lang aktiviert. Danach wird die Leiterplatte von Hand mit einem Elektrolytkondensator (15 D der Fa. Philips) bestückt und mit einer Infrarotlampe (Infrarot-Trocknungsaufsatz der Fa. Sartorius, 250 W, Temperatur = 72°C) 1 Min. bestrahlt.

Danach wird die resultierende bestückte Leiterplatte in ein Schlepplötbad (Fa. Zevatron Typ EFT-1) eingebracht. Die Leiterplatte wird mit Geschwindigkeitsstufe 4 in einen auf 250°C erhitzten Behälter mit geschmolzenem Lot eingefahren und 3 sec. eingetaucht belassen. Während des Verlötens tritt keine Ablösung des Elco-Gehäuses von der gedruckten Leiterplatte auf. Die Verlötung ist völlig in Ordnung.

Das Eintauchen wird sofort wiederholt, ohne daß daraufhin eine Ablösung des Elco-Gehäuses von der gedruckten Leiterplatte eintritt.

### Vergleichsbeispiel 2

Ein gebräuchlicher Einkomponenten-Epoxid-Klebstoff (RD860002M der Fa. Heraeus) für die Befestigung von SMD-Bauteilen auf Leiterplatten wird mittels eines Dispensers auf die gleiche gedruckte Leiterplatte wie im Beispiel 5 aufgetragen. Danach wird ein quaderförmiger SMD-Bauteil (Elektrolytkondensator 15 D der Fa. Philips) darauf aufgebracht und die Leiterplatte anschließend zur Härtung der Klebstoffschicht mit einer Infrarotlampe (Trocknungsaufsatz der Fa. Sartorius, 250 W, Temperatur = 72°C) 3 Min. bestrahlt.

Danach wird die resultierende bestückte Leiterplatte in ein Schlepplötbad (Fa. Zevatron Typ EFT-1) eingebracht. Die Leiterplatte wird mit Geschwindigkeitsstufe 4 in einen auf 250°C erhitzten Behälter mit geschmolzenem Lot eingefahren und 3 sec. eingetaucht belassen. Dabei löst sich der SMD-Bauteil von der gedruckten Leiterplatte ab. Der gebräuchliche Einkomponenten-Epoxid-Klebstoff ist unter diesen milden Aushärtungsbedingungen (1 Min. thermische Aushärtung bei 72°C) zur Verklebung von SMD-Bauteilen nicht geeignet.

### Vergleichsbeispiel 3

Ein gebräuchlicher Einkomponenten-Epoxid-Klebstoff für die Befestigung von SMD-Bauteilen auf Leiterplatten (Amicon D-124-F der Fa. Emerson and Cuming) wird wie im Vergleichsbeispiel 2 beschrieben auf eine gedruckte Leiterplatte aufgebracht und unter denselben Bedingungen ausgehärtet und im Schlepplötbad geprüft.

Während des Verlötens löst sich der SMD-Bauteil von der gedruckten Leiterplatte ab. Dieser gebräuchliche Einkomponenten-Epoxid-Klebstoff ist unter diesen milden Aushärtungsbedingungen als SMD-Klebstoff nicht geeignet.

### Beispiel 6

Es wird eine Harzzusammensetzung durch gleichmäßiges Mischen von 100 Gew.-Teilen 3,4-Epoxycyclohexylmethyl-3′,4′-epoxycyclohexylcarboxylat, 2,5 Gew.-Teilen Cumolhydroperoxid, 3 Gew.-Teilen Irgacure® 261 (der Fa. Ciba-Geigy) und 3 Gew.-Teilen hydrophobierten Siliciumdioxid-Pulvers mit einer spezifischen Oberfläche von 71 m²/g und mittleren Teilchengröße von kleiner 100 nm (R-202 der Fa. Degussa) unter Rühren hergestellt.

Die Harzzusammensetung weist eine Viskosität von 0,95 Pa.s auf (Haake-Viskosimeter Rotovisko RV 100, PKI 0.5/28, 10 %D).

Aus dieser Harzzusammensetzung werden anschließend mittels eines Stiftes (pin transfer) zwei Klebstofftropfen auf einen SMD-Bauteil (IC D7508G der Fa. NEC) aufgebracht.

Die Klebstofftropfen werden anschließend mit einem Bestrahlungsgerät, welches aktinisches Licht im Bereich von 400 bis 500 nm aussendet (Curelight 01 der Fa. Precon, ca. 100 mW/cm²), 15 sec. aktiviert. Danach wird eine gedruckte Leiterplatte mit diesem SMD-Bauteil bestückt und mit einer Infrarotlampe (IR-Trocknungsaufsatz YTC01L der Fa. Sartorius, 250 W) 2 Min. bestrahlt (Temperatur = 72°C).

Danach wird die resultierende bestückte Leiterplatte in ein Schlepplötbad (Fa. Zevatron Typ EFT-1) eingebracht. Die Leiterplatte wird mit maximaler Geschwindigkeitsstufe 10 in einen auf 250°C erhitzten Behälter mit geschmolzenem Lot eingefahren und 3 sec. eingetaucht belassen. Während des Verlötens tritt keine Ablösung des SMD-Bauteils von der gedruckten Leiterplatte auf. Die Verlötung ist einwandfrei.

Das Eintauchen wird 3 x wiederholt. Hierbei tritt keine Ablösung des SMD-Bauteils von der gedruckten Leiterplatte auf.

### Vergleichsbeispiel 4

Ein gebräuchlicher Einkomponenten-Epoxid-Klebstoff für die Befestigung von SMD-Bauteilen auf Leiterplatten (Amicon D124-F der Fa. Emerson and Cuming) wird wie in Beispiel 6 mittels eines Stiftes auf ein SMD-Bauteil (D7508G der Fa. NEC) aufgetragen und danach 5 Min. mit derselben Infrarotlampe wie in Beispiel 6 bestrahlt.

Danach wird die resultierende bestückte Leiterplatte unter denselben Bedingungen wie in Beispiel 6 in den Behälter mit geschmolzenem Lot eingefahren. Dabei löst sich das SMD-Bauteil von der Leiterplatte.

Dieser gebräuchliche Einkomponenten-Epoxid-Klebstoff ist unter diesen milden Aushärtungsbedingungen (5 Min. thermische Aushärtung bei 72°C) für die Verklebung von SMD-Teilen nicht geeignet.

## Patentansprüche

1. Verfahren zum Befestigen von Bauteilen auf einer Leiterplatte durch Auftragen eines photoaktivierbaren Klebstoffs auf vorbestimmte Flächen der Bauteile oder der Leiterplatte, Bestücken der Leiterplatte mit den Bauteilen, Härten der Klebeverbindung bei einer Temperatur zwischen 60 und 140°C sowie Herstellung von Lötverbindungen zwischen den Bauteilen und der Leiterplatte, dadurch gekennzeichnet, daß ein Klebstoff, bestehend aus
a) 10 bis 99,95 Gew.% mindestens eines kationisch härtbaren Harzes und/oder eines kationisch polymerisierbaren Monomers,
b) 0,05 bis 10 Gew.% mindestens eines Photoinitiators, der unter Lichteinwirkung Lewis- oder Brönsted-Säuren bildet,
c) 0 bis 89,95 Gew.% eines oder mehrerer Füllstoffe, thioxotropierender Mittel und/oder Haftvermittler,
durch Bestrahlen mit Licht von einer Wellenlänge im Bereich von 200 bis 600 nm vor dem Bestücken der Leiterplatte soweit aktiviert wird, daß die gewünschte Initialklebrigkeit erhalten bleibt und keine Hautbildung an der Klebstoffoberfläche eintritt.

2. Verfahren nach Anspruch 1, dadurch gekennzeichnet, daß die Aktivierung des Klebstoffs durch Bestrahlen mit Licht einer Wellenlänge von 300 bis 500 nm während 0,5 bis 300 sec. erfolgt.

3. Verfahren nach Anspruch 2, dadurch gekennzeichnet, daß die Aktivierung des Klebstoffs durch Bestrahlen mit Tageslicht mit einer Wellenlänge von 400 bis 500 nm erfolgt.

4. Verfahren nach einem der Ansprüche 1 bis 3, dadurch gekennzeichnet, daß das Härten der Klebeverbindung nach dem Bestücken der Leiterplatte während einer Zeitspanne von bis zu 15 Min. erfolgt.

5. Verfahren nach einem der Ansprüche 1 bis 4, dadurch gekennzeichnet, daß als photoaktivierbarer Klebstoff eine kationisch härtbare, vor der Aktivierung fließfähige Klebstoffmasse mit einer Viskosität von 0,05 bis 1000 Pa.s verwendet wird.

6. Verfahren nach Anspruch 5, dadurch gekennzeichnet, daß eine Klebstoffmasse mit einer Viskosität von, vor ihrer Aktivierung, 0,4 bis 200 Pa.s verwendet wird.

7. Verfahren nach einem der Ansprüche 1 bis 6, dadurch gekennzeichnet, daß eine Klebstoffmasse verwendet wird, die besteht aus:
a) 70 bis 98 Gew.% mindestens eines kationisch härtbaren Harzes und/oder eines kationisch polymerisierbaren Monomers;
b) 2 bis 6 Gew.% mindestens eines Photoinitiators, der unter Lichteinwirkung Lewis oder Brönsted-Säuren bildet;
c) 0 bis 28 Gew.% eines oder mehrerer Füllstoffe, thixotropierender Mittel und/oder Haftvermittler.

8. Verfahren nach einem der Ansprüche 1 bis 7, dadurch gekennzeichnet, daß eine Klebstoffmasse verwendet wird, die besteht aus:
a) 10 bis 89,9 Gew.% mindestens eines kationisch härtbaren Harzes und/oder eines kationisch polymerisierbaren Monomers;
b) 0,05 bis 10 Gew.% mindestens eines Photoinitiators, der unter Lichteinwirkung Lewis- oder Brönsted-Säuren bildet;
c) 0 bis 89,9 Gew.% eines oder mehrerer Füllstoffe, thixotropierender Mittel und/oder Haftvermittler;
d) 10 bis 80 Gew.% mindestens eines nach einem radikalischen Polymerisationsmechanismus polymerisierenden Harzes und/oder Monomers;
e) 0,05 bis 5 Gew.% mindestens eines Photoinitiators, der unter Lichteinwirkung Radikale erzeugt;
f) gegebenenfalls 0,05 bis 5 Gew.% mindestens eines Photosensibilisators und/oder Aktivators.

9. Verfahren nach Anspruch 7 oder 8, dadurch gekennzeichnet, daß die Komponente a) der Klebstoffmasse mindestens teilweise aus den Diglycidylethern zweiwertiger Phenole und/oder zweiwertiger aliphatischer Alkohole besteht.

## Claims

1. A method for the attachment of components to a circuit board comprising applying a photoactivatable adhesive to selected areas of the components or of the circuit board, fitting the components to the circuit board, curing the adhesive bonds at a temperature between 60 and 140°C and producing soldered joints between the components and the circuit board characterized in that an adhesive is activated by irradiation with light having a wavelength in a range of 200 to 600 nm prior to said fitting to said circuit board to such an extent that the desired initial tackiness is maintained and no skin formation on the surface of the adhesive takes place, with said adhesive consisting of
(a) 10 to 99.95 % of at least one cationically curable resin and/or cationically polymerizable monomer;
(b) 0.05 to 10 % by weight of at least one photoinitiator, which under the influence of light forms Lewis or Bronsted acids; and
(c) 0 to 89.95 % by weight of at least one filler, thixotropifying agent and/or adhesion promotor.

2. The method as claimed in claim 1 wherein the activation of the adhesive is performed by irradiation with light having a wavelength of 300 to 500 nm for a time of 0.5 to 300 sec.

3. The method as claimed in claim 2, wherein the activation of the adhesive is performed by irradiation with daylight having a wavelength of 400 to 500 nm.

4. The method of any one of claims 1 to 3, wherein said curing of the adhesive bond after said fitting the component to the circuit board is performed during an interval amounting to up to 15 minutes.

5. The method of any one of claims 1 to 4, wherein a cationically curable adhesive composition being able to flow prior to activation and having a viscosity of 0.05 to 1000 Pa.s is used as said photoactivatable adhesive.

6. The method as claimed in claim 5, wherein an adhesive composition is used having a viscosity prior to activation of 0.4 to 200 Pa.s.

7. The method of any one of claims 1 to 6, wherein an adhesive composition is used which consists of:
(a) 70 to 98 % by weight of at least one cationically curable resin and/or cationically polymerizable monomer;
(b) 2 to 6 % by weight of at least one photoinitiator, which under the influence of light forms Lewis or Bronsted acids; and
(c) 0 to 28 % by weight of at least one filler, thixotropifying agent and/or adhesion promotor.

8. The method of any one of claims 1 to 7, wherein an adhesive composition is used which consists of:
(a) 10 to 89.9 % by weight of at least one cationically curable resin and/or cationically polymerizable monomer;
(b) 0.05 to 10 % by weight of at least one photoinitiator, which under the action of light forms Lewis or Bronsted acids;
(c) 0 to 89.9 % by weight of at least one filler, thixotropifying agent and/or adhesion promotor;
(d) 10 to 80 % by weight of at least one resin and/or monomer polymerizing in accordance with a radicalic polymerization mechanism;
(e) 0.05 to 5 % by weight of at least one photoinitiator, which under the action of light produces radicals; and
(f) if needed 0.05 to 5 % by weight of at least one photosensitizer and/or activator.

9. The method of claim 7 or 8, characterized in that the component (a) of the adhesive composition consists at least in part of the diglycidylethers of divalent phenols and/or of divalent aliphatic alcohols.

## Revendications

1. Procédé pour fixer des composants sur une carte imprimée, dans lequel on applique un adhésif photo-activable sur des surfaces prédéfinies des composants ou de la carte imprimée, on équipe la carte imprimée des composants, on durcit le composé adhésif à une température comprise entre 60 et 140°C, et on réalise des assemblages soudés entre les composants et la carte imprimée, caractérisé en ce qu'un adhésif, constitué :
a) de 10 à 99,95 % en poids d'au moins une résine à durcissement cationique et/ou d'un monomère à polymérisation cationique,
b) de 0,05 à 10 % en poids d'au moins un photo-amorceur qui, sous l'action de la lumière, forme des acides de Lewis ou de Brönsted,
c) de 0 à 89,95 % en poids d'une ou plusieurs charges, un ou plusieurs agents thixotropiques et/ou promoteurs d'adhérence,
est activé par exposition à une lumière ayant une longueur d'onde comprise entre 200 et 600 nm, et ce avant l'équipement de la carte imprimée, jusqu'à ce que se conserve le collant initial souhaité, et que n'apparaisse aucune formation de peau sur la surface de l'adhésif.

2. Procédé selon la revendication 1, caractérisé en ce que l'activation de l'adhésif se fait par exposition à une lumière ayant une longueur d'onde de 300 à 500 nm pendant 0,5 à 300 s.

3. Procédé selon la revendication 2, caractérisé en ce que l'activation de l'adhésif est réalisée par exposition à une lumière du jour ayant une longueur d'onde de 400 à 500 nm.

4. Procédé selon l'une des revendications 1 à 3, caractérisé en ce que le durcissement du composé adhésif, après équipement de la carte imprimée, est réalisé pendant un laps de temps allant jusqu'à 15 mn.

5. Procédé selon l'une des revendications 1 à 4, caractérisé en ce qu'on utilise comme adhésif photo-activable une composition adhésive durcissable par durcissement cationique, fluide avant l'activation, ayant une viscosité de 0,05 à 100 Pa.s.

6. Procédé selon la revendication 5, caractérisé en ce qu'on utilise une composition adhésive ayant, avant son activation, une viscosité de 0,4 à 200 Pa.s.

7. Procédé selon l'une des revendications 1 à 6, caractérisé en ce qu'on utilise une composition adhésive constituée :
a) de 70 à 98 % au moins d'une résine à durcissement cationique et/ou d'un monomère à polymérisation cationique,
b) de 2 à 6 % en poids au moins d'un photo-amorceur qui, sous l'action de la lumière, forme des acides de Lewis ou de Brönsted,
c) de 0 à 28 % en poids d'une ou plusieurs charges, un ou plusieurs agents thixotropiques, promoteurs d'adhérence.

8. Procédé selon l'une des revendications 1 à 7, caractérisé en ce qu'on utilise une composition adhésive constituée :
a) de 10 à 89,9 % en poids au moins d'une résine à durcissement cationique et/ou d'un monomère à polymérisation cationique,
b) de 0,05 à 10 % en poids au moins d'un photo-amorceur, formant sous l'action de la lumière, des acides de Lewis ou de Brönsted,
c) de 0 à 89,9 % en poids d'une ou plusieurs charges, un ou plusieurs agents thixotropiques et/ou promoteurs d'adhérence,
d) de 10 à 80 % en poids d'au moins une résine et/ou un monomère polymérisable par un mécanisme de polymérisation radicalaire,
e) de 0,05 à 5 % en poids d'au moins un photo-amorceur, qui forme des radicaux sous l'action de la lumière,
f) éventuellement, de 0,05 à 5 % en poids d'au moins un photosensibilisateur et/ou activateur.

9. Procédé selon la revendication 7 ou 8, caractérisé en ce que le constituant a) de la composition adhésive est constitué, au moins partiellement, des étherdiglycidyliques de diphénols et/ou de dialcools aliphatiques.
